# DEMANDE DE BREVET EUROPEEN

(11) **EP 3 330 977 A1**
(43) Date de publication de la demande: **06.06.2018**
(21) Numéro de dépôt: 17202279.0
(22) Date de dépôt: 17.11.2017
(51) Int. Cl.: H01F 1/00, H01F 1/113, H01F 1/28, H01F 1/37, H05K 9/00

(54) **MATÉRIAU MAGNÉTIQUE ET SON PROCÉDÉ DE FABRICATION**

(30) Priorité: 21.11.2016 FR 1661264
(71) Demandeur: Commissariat à l'Energie Atomique et aux Energies Alternatives, 75015 Paris (FR)
(72) Inventeur: BENWADIH, Mohammed, 94500 CHAMPIGNY-SUR-MARNE (FR)
(74) Mandataire: Cabinet Beaumont

(57) **Abrégé**

L'invention concerne un matériau magnétique et isolant électriquement comprenant une matrice (10) en un polymère isolant électriquement dans laquelle sont dispersées de façon homogène des particules (14) d'une substance magnétique comprenant au moins un métal de transition.

## Description

### Domaine

La présente demande concerne les matériaux magnétiques et leur procédé de fabrication.

### Exposé de l'art antérieur

Pour certaines applications, il est souhaitable de pouvoir former des films magnétiques non conducteurs électriquement. Un exemple d'application concerne les circuits électroniques comprenant des antennes comportant une piste conductrice électriquement formée sur un film magnétique non conducteur électriquement.

Le principe de réaliser un film magnétique non conducteur en mélangeant des particules magnétiques dans une matrice en un polymère non conducteur électriquement est connu.

Toutefois, la réalisation d'un film dans lequel les particules magnétiques sont dispersées de façon homogène dans la matrice peut être difficile. En effet, les particules magnétiques s'attirent mutuellement et se présente donc sous la forme d'une poudre comprenant des agglomérats de particules. De ce fait, lorsque la poudre est ajoutée à une solution contenant un précurseur du polymère, il peut être difficile de disperser efficacement les particules dans la solution avant la formation du polymère.

Il serait donc souhaitable d'obtenir un procédé de fabrication d'un matériau magnétique non conducteur électriquement, notamment pour la formation d'un film, comprenant une matrice non conductrice électriquement dans laquelle sont dispersées des particules magnétiques de façon sensiblement homogène.

### Résumé

Un objet d'un mode de réalisation est de pallier tout ou partie des inconvénients des matériaux magnétiques et de leurs procédés de fabrication décrits précédemment.

Un autre objet d'un mode de réalisation est que le procédé de fabrication du matériau magnétique est simple et peut être mis en oeuvre à une échelle industrielle.

Un autre objet d'un mode de réalisation est que le matériau magnétique peut être appliqué par des techniques d'impression.

Un autre objet d'un mode de réalisation est que le matériau magnétique peut être fabriqué à coût réduit.

Ainsi, un mode de réalisation prévoit un Matériau magnétique et isolant électriquement comprenant une matrice en un polymère isolant électriquement dans laquelle sont dispersées de façon homogène des particules d'une substance magnétique comprenant au moins un métal de transition.

Selon un mode de réalisation, le polymère est choisi parmi le groupe comprenant le poly(méthacrylate de méthyle), le polystyrène, les fluoropolymères, le polybutadiène, et les copolymères ou les mélanges d'au moins deux de ces composés.

Selon un mode de réalisation, la substance magnétique est choisie parmi le groupe comprenant les éléments magnétiques, les ferrites, les oxydes magnétiques et les alliages magnétiques.

Selon un mode de réalisation, la taille moyenne des particules est comprise entre 0,01 µm et 0,5 µm.

Selon un mode de réalisation, chaque particule est au moins partiellement entourée de molécules greffées à ladite particule et comprenant un groupement hydrophobe et un groupement hydrophile.

Selon un mode de réalisation, les molécules sont choisies parmi le groupe comprenant le 4-fluorobenzo[d]thiazole-2-thiol, le 4-amino-2-fluorobenzenethiol, le benzènethiol, le 4-nitrobenzènethiol, le 4-méthylbenzènethiol, le 4-hydroxybenzènethiol, le 4-méthoxybenzènethiol, le 4-fluorobenzènethiol, le pentafluorobenzènethiol, le 4-chlorobenzènethiol, le pentachlorobenzènethiol, le 4-bromobenzènethiol, et un mélange d'au moins deux de ces composés.

Selon un mode de réalisation, les molécules comprennent au moins un groupement choisi parmi le groupe comprenant les groupements silanes, les amines, les acides phosphoriques, les acides carboxyliques ou les isocyanates.

Un mode de réalisation prévoit également un film magnétique et isolant électriquement comprenant le matériau tel que défini précédemment.

Un mode de réalisation prévoit également un procédé de fabrication du matériau magnétique et isolant électriquement tel que défini précédemment, comprenant les étapes successives suivantes :
exposition d'une poudre des particules de la substance magnétique à des impulsions d'un rayonnement ultraviolet d'où il résulte une désaimantation temporaire des particules ;
mélange de la poudre à un solvant contenant, en outre, un précurseur du polymère ; et
polymérisation du précurseur pour former la matrice du polymère isolant électriquement dans laquelle les particules sont dispersées de façon homogène.

Selon un mode de réalisation, le rayonnement a une fluence comprise entre 1 J/cm² et 100 J/cm².

Selon un mode de réalisation, le nombre d'impulsions est supérieur à 50.

Selon un mode de réalisation, la durée de chaque impulsion est comprise entre 10 ns et 5 ms.

Selon un mode de réalisation, le procédé comprend en outre le greffage aux particules de molécules comprenant un groupement hydrophobe et un groupement hydrophile.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et schématique, d'un mode de réalisation d'un film magnétique non conducteur électriquement ; et
la figure 2 représente, sous la forme d'un schéma-bloc, un mode de réalisation d'un procédé de fabrication du film magnétique représenté en figure 1.

### Description détaillée

De mêmes éléments ont été désignés par de mêmes références dans les différentes figures. Par souci de clarté, seuls les éléments utiles à la compréhension des modes de réalisation décrits ont été représentés et sont détaillés. Sauf précision contraire, les expressions "approximativement", "sensiblement", "environ" et "de l'ordre de" signifient à 10 % près, de préférence à 5 % près.

Dans la suite de la description, on appelle "matériau isolant électriquement" ou "matériau diélectrique" un matériau dont la résistivité électrique est supérieure à 10⁵ Ω.m et on appelle "matériau conducteur électriquement" un matériau dont la résistivité électrique est inférieure à 0,1 Ω.m.

Le terme "particule" tel qu'utilisé dans le cadre de la présente demande doit être compris dans un sens large et correspond non seulement à des particules compactes ayant plus ou moins une forme sphérique mais aussi à des particules anguleuses, des particules aplaties, des particules en forme de flocons, des particules en forme de fibres, ou des particules fibreuses, etc. On comprendra que la "taille" des particules dans le cadre de la présente invention signifie la plus petite dimension transversale des particules. A titre d'exemple, dans le cas de particules en forme de fibres, la taille des particules correspond au diamètre des fibres. On entend par particules d'un matériau les particules prises individuellement (c'est-à-dire les éléments unitaires du matériau) sachant que le matériau peut se présenter sous la forme d'agglomérats de particules.

Par le terme "taille moyenne", on entend selon la présente invention la taille de la particule qui est supérieure à la taille de 50 % en volume des particules et inférieure à la taille de 50 % en volume des particules d'une distribution de particules. Ceci correspond au d₅₀. La granulométrie des particules peut être mesurée par granulométrie laser en utilisant, par exemple, un Malvern Mastersizer 2000.

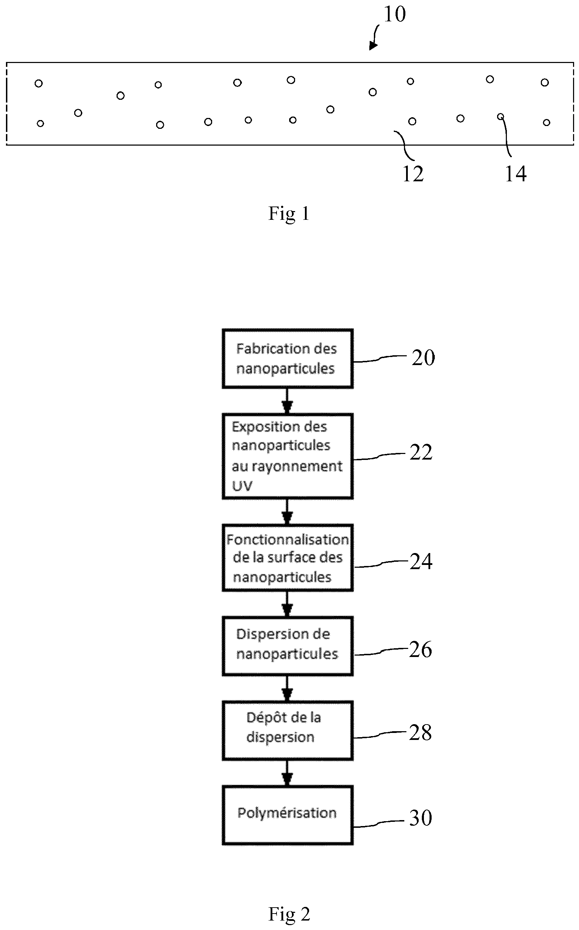

La figure 1 est une vue en coupe, partielle et schématique, d'un mode de réalisation d'un film magnétique 10. Le film 10 est composé d'un matériau magnétique comprenant une matrice 12 en une substance diélectrique dans laquelle sont dispersées des particules 14 en une substance magnétique. Selon un mode de réalisation, les particules 14 sont dispersées de façon sensiblement homogène dans la matrice 12. Ceci signifie que la densité volumique locale des particules magnétiques 14 dans le matériau est sensiblement constante dans tout le matériau et égale à la densité volumique moyenne des particules magnétiques 14 dans le matériau.

Selon un mode de réalisation, la taille moyenne des particules 14 est comprise entre 0,01 µm et 0,5 µm, de préférence entre 0,02 µm et 0,2 µm, encore plus préférentiellement entre 0,05 µm et 0,1 µm. Selon un mode de réalisation, la proportion de particules en poids dans le film magnétique 10 est comprise entre 1 % et 50 %. La densité volumique des particules magnétiques 14 dans le film 10 peut aller jusqu'à 50 % du volume total.

Les particules 14 peuvent comprendre au moins 90 % en poids de la substance magnétique. La substance magnétique peut comprendre au moins un métal de transition ou un mélange ou alliage de deux métaux de transition ou de plus de deux métaux de transition. Un métal de transition est un élément qui a une sous-couche d incomplète ou qui peut donner un cation ayant une sous-couche d incomplète. La substance magnétique peut correspondre à un élément magnétique ou à un alliage magnétique, notamment un alliage métallique et magnétique ou un alliage non métallique et magnétique, notamment un oxyde magnétique.

La substance magnétique peut être choisie parmi le groupe comprenant le cobalt (Co), le nickel (Ni), un alliage (Fe-Co) de fer et de cobalt, un alliage (Fe-Ni) de fer (Fe) et de nickel, un alliage (Co-Ni) de cobalt et de nickel, un alliage de cobalt et de carbone (C), un alliage (NiC) de nickel et de carbone, un alliage (NiZn) de nickel et de zinc (Zn), un alliage (NiSr) de nickel et de strontium (Sr), un alliage (SrFe) de strontium et de fer et un mélange ou alliage d'au moins deux de ces composés.

La substance magnétique peut, en outre, être choisie parmi le groupe comprenant une ferrite nickel-zinc (NiₐZn₁₋ₐFe₂O₄), une ferrite (SrFe₁₂O₁₉) de strontium, une ferrite (CuFe₂O₄) de cuivre, une ferrite (BaFe₁₂O₁₉) de baryum et un mélange ou alliage d'au moins deux de ces composés.

Selon un mode de réalisation, la substance diélectrique est un polymère. Selon un mode de réalisation, la substance diélectrique est choisie parmi le groupe comprenant le poly (méthacrylate de méthyle) (PMMA), le polystyrène (PS), les fluoropolymères (notamment les polymères perfluorés comme le produit commercialisé sous l'appellation CYTOP par la société AGC Chemicals Europe), le polybutadiène (BR), et les copolymères ou les mélanges d'au moins deux de ces composés.

L'épaisseur du film magnétique 10 est adaptée en fonction de l'application envisagée. Selon un mode de réalisation dans lequel le film magnétique 10 est utilisé dans un circuit électronique comme support d'une antenne, notamment dans le domaine des radiofréquences ou des hautes fréquences, l'épaisseur du film magnétique 10 est de préférence comprise entre 100 nm et 10 µm, par exemple environ 1 µm.

Selon un mode de réalisation, les particules 14 ont une composition uniforme. Selon un autre mode de réalisation, chaque particule 14 peut comprendre un coeur de la substance magnétique et une coquille entourant, en totalité ou seulement en partie, le coeur. La coquille peut être en une substance différente de la substance magnétique.

Selon un mode de réalisation, la coquille est en une substance qui empêche la formation d'oxyde à partir de la substance magnétique. Dans ce but, la coquille peut être en une substance choisie dans le groupe comprenant le graphène, le carbone, le fluor et un mélange d'au moins deux, par exemple trois, de ces composés. La coquille peut être en graphène dans le cas où la substance magnétique est le Co ou un alliage Co/C. La coquille peut être en carbone dans le cas où la substance magnétique est le Ni ou un alliage Ni/C.

Selon un mode de réalisation, la coquille est en une substance qui facilite la dispersion des particules 14 dans la matrice 12 lors de la fabrication du film magnétique comme cela est décrit plus en détail par la suite. Dans ce but, la coquille peut être en une substance issue du greffage, en surface du matériau magnétique, d'un composé comprenant un groupement hydrophile, un groupement hydrophobe et un groupement adapté à se greffer sur la substance magnétique. Le composé peut être choisi dans le groupe comprenant le 4-fluorobenzo[d]thiazole-2-thiol (C₇H₄FNS₂), le 4-amino-2-fluorobenzenethiol (C₆H₆FNS), le benzènethiol (BT), le 4-nitrobenzènethiol (NBT), le 4-méthylbenzènethiol (MBT), le 4-hydroxybenzènethiol (HBT), le 4-méthoxybenzènethiol (MOBT), le 4-fluorobenzènethiol (FBT), le pentafluorobenzènethiol (PFBT), le 4-chlorobenzènethiol (CBT), le pentachlorobenzènethiol (PCBT), le 4-bromobenzènethiol (BBT), et un mélange d'au moins deux de ces composés. La coquille peut correspondre à un nombre réduit de couches atomiques du composé, par exemple une monocouche atomique.

La figure 2 représente, sous la forme d'un schéma-bloc, un mode de réalisation d'un procédé de fabrication du film magnétique 10 représenté en figure 1.

A l'étape 20, les particules magnétiques sont formées. Les procédés de fabrication de particules magnétiques sont bien connus de l'homme du métier et ne sont pas décrits en détail par la suite. Un exemple de procédé de fabrication de particules magnétiques est décrit dans la publication de Dong-Hwang Chen et Szu-Han Wu intitulée "Synthesis of Nickel Nanoparticles in Water-in-Oil Microemulsions" (Chem. Mater. 2000, 12, 1354-1360). Les particules sont de préférence sous la forme d'une poudre. Le procédé se poursuit à l'étape 22. Des particules magnétiques commercialisées par la société Sigma-Aldrich sous l'appellation Turbobeads ou commercialisées par la société Skyspring Nanomaterials.

A l'étape 22, le procédé comprend l'application d'impulsions brèves d'un rayonnement ultraviolet (UV), ou flashs ultraviolets, sur les particules. Ceci permet de chauffer très rapidement les particules jusqu'à dépasser la température de Curie de la substance magnétique composant les particules. Les particules perdent alors temporairement leur aimantation permanente. La durée de la désaimantation peut être de 1 minute à quelques heures, par exemple 2 heures.

Par rayonnement UV, on entend un rayonnement dont les longueurs d'onde sont, au moins en partie, comprises entre 190 nm et 350 nm. Le rayonnement UV peut être fourni par une lampe, par exemple une lampe Xénon qui peut fournir un rayonnement qui s'étend sur une plage de longueurs d'onde plus large que la plage de 190 nm à 350 nm, par exemple sur la plage de 150 nm à 1000 nm. La distance entre la source d'émission des impulsions UV et les particules est comprise entre 1 cm et 10 cm. Selon un mode de réalisation, la durée d'une impulsion UV est comprise entre 10 ns et 5 ms, de préférence entre 500 µs et 2 ms. La durée entre deux impulsions UV successives peut être comprise entre 0,2 seconde et 5 secondes. La fluence du rayonnement UV peut être comprise entre 1 J/cm² et 100 J/cm², de préférence entre 10 J/cm² et 25 J/cm². Le nombre d'impulsions est compris entre 25 et 100, de préférence supérieur à 50.

L'étape 22 peut être mise en oeuvre avec l'équipement commercialisé par la société Novacentrix sous l'appellation Pulseforge ou l'équipement commercialisé par la société Xénon sous l'appellation Sinteron.

L'inventeur a, en outre, mis en évidence que, à l'étape 22, on obtient la formation d'hydrogène en surface des particules à partir des molécules d'eau présentes en surface des particules. L'hydrogène réagit avec les éventuels oxydes présents en surface des particules et entraîne le retrait au moins partiel de ces oxydes par un procédé de réduction. Une désoxydation de la surface des particules magnétiques est ainsi obtenue. Le procédé se poursuit à l'étape 24.

A l'étape 24, une fonctionnalisation de la surface des particules est réalisée. Dans ce but, les particules sont mélangées avec un composé de façon à obtenir le greffage du composé en surface des particules. Le composé comprend un groupement hydrophile, un groupement hydrophobe et un groupement adapté à se greffer sur la substance magnétique. Le composé peut être choisi dans le groupe comprenant le 4-fluorobenzo[d]thiazole-2-thiol (C₇H₄FNS₂), le 4-amino-2-fluorobenzenethiol (C₆H₆FNS), le benzènethiol (BT), le 4-nitrobenzènethiol (NBT), le 4-méthylbenzènethiol (MBT), le 4-hydroxybenzènethiol (HBT), le 4-méthoxybenzènethiol (MOBT), le 4-fluorobenzènethiol (FBT), le pentafluorobenzènethiol (PFBT), le 4-chlorobenzènethiol (CBT), le pentachlorobenzènethiol (PCBT), le 4-bromobenzènethiol (BBT), et un mélange d'au moins deux de ces composés.

Dans le cas où les particules comportent une phase oxyde, on utilisera un composé comprenant au moins un groupement chimique capable de se greffer sur les oxydes, notamment les groupements silanes, les amines, les acides phosphoriques, les acides carboxyliques ou les isocyanates.

L'étape 24 peut être suivie d'une étape de lavage des particules dont la surface a été fonctionnalisée pour retirer les résidus de la réaction de greffage. L'étape 24 peut ne pas être présente, en particulier lorsque les particules sont entourées d'une couche de graphène ou de carbone. Le procédé se poursuit à l'étape 26.

A l'étape 26, les particules temporairement démagnétisées sont mélangées dans un solvant avec un composé précurseur du polymère pour obtenir une solution dans laquelle les particules sont dispersées. Le solvant peut être un solvant polaire ou apolaire. Le solvant peut être choisi parmi le groupe comprenant le cyclopentanone, le dyméthylsulphoxide (DMSO), le dyméthylformamide (DMF), le gamma-butyrolactone (GBL), le méthyléthylcétone (MEK), le dyméthylacétamide (DMAc) et le N-méthyl-E-pyrrolidone (NMP).

Les particules ayant perdu temporairement leur aimantation, la dispersion des particules dans le solvant est facilitée. Une agitation de la solution peut être prévue. Dans le cas où une fonctionnalisation de la surface des particules a été réalisée, le composé greffé en surface des particules comprend de préférence un groupement hydrophile. Ceci permet de faciliter la dispersion des particules dans le solvant. En outre, le groupement hydrophile permet de réduire l'affinité des particules magnétiques entre elles. De plus, le composé greffé en surface des particules comprend de préférence un groupement hydrophobe. Ceci permet d'augmenter l'éloignement des molécules d'eau éventuellement présentes dans le solvant de la surface des particules et ainsi de réduire l'oxydation du matériau magnétique en surface des particules.

Selon la nature de la matrice en polymère, un composé adapté à favoriser la réaction de polymérisation, également appelé amorceur, peut en outre être ajouté à la solution. Dans le cas où le polymère est le PMMA, le composé précurseur du polymère peut être un monomère (méth)acrylique. L'amorceur peut favoriser la réaction de polymérisation sous l'action d'un rayonnement UV ou d'un rayonnement de lumière visible. L'amorceur peut alors être choisi parmi le groupe comprenant la benzophénome, le benzile, l'azobisisobutyronitrile. L'amorceur peut favoriser la réaction de polymérisation sous l'action du chauffage. L'amorceur peut alors être choisi parmi le groupe comprenant le mélanine-formaldéhyde.

La solution comprend de 1 % à 30 %, de préférence de 1 % à 20 %, en poids de l'ensemble comprenant les particules, le composé précurseur du polymère et éventuellement l'amorceur, et de 70 % à 99 %, de préférence de 80 % à 99 %, en poids du solvant. De façon avantageuse, la concentration en poids du solvant est choisie pour ajuster la viscosité de la solution obtenue afin de permettre la mise en oeuvre de techniques d'impression. Le procédé se poursuit à l'étape 28.

A titre de variante, les étapes 24 et 26 peuvent être confondues. Dans ce cas, le composé destiné à se greffer en surface des particules 14 est ajouté à la solution contenant les particules, le solvant et les précurseurs du polymère.

A l'étape 28, il est réalisé une couche liquide ou visqueuse à partir de la solution obtenue à l'étape 26. Le procédé de formation d'une couche liquide ou visqueuse de la solution peut correspondre à un procédé dit additif, par exemple par impression directe de la solution aux emplacements souhaités, par exemple par impression par jet d'encre, héliographie, sérigraphie, flexographie, revêtement par pulvérisation (en anglais spray coating) ou dépôt de gouttes (en anglais drop-casting). Le procédé de formation de la couche liquide ou visqueuse peut correspondre à un procédé dit soustractif, dans lequel la couche liquide est déposée sur la totalité de la structure et dans lequel les portions non utilisées sont ensuite retirées, par exemple par photolithographie ou ablation laser. Selon le matériau considéré, le dépôt sur la totalité de la structure peut être réalisé par exemple par voie liquide, par pulvérisation cathodique ou par évaporation. Il peut s'agir notamment de procédés du type dépôt à la tournette, revêtement par pulvérisation, héliographie, revêtement par filière (en anglais slot-die coating), revêtement à la lame (en anglais blade-coating), flexographie ou sérigraphie. Le procédé se poursuit à l'étape 30.

A l'étape 30, la réaction de polymérisation est mise en oeuvre pour obtenir la matrice solide dans laquelle sont dispersées les particules 14. Le film 10 représenté en figure 1 est alors obtenu. Selon le polymère composant la matrice 12, la réaction de polymérisation peut nécessiter l'exposition de la solution à un rayonnement UV ou à de lumière visible. Selon le polymère composant la matrice 12, la réaction de polymérisation peut nécessiter le chauffage de la couche liquide ou visqueuse déposée à l'étape 28. Selon un mode de réalisation, un recuit thermique à une température supérieure à 50°C, par exemple comprise entre 50°C et 130°C, peut être mis en oeuvre pendant plusieurs minutes.

La désaimantation des particules 14 peut cesser avant que l'étape 30 ne soit mise en oeuvre. Toutefois, ceci n'entraîne pas la formation d'agglomérats dans la mesure où les particules sont déjà dispersées dans la solution.

## Revendications

1. Procédé de fabrication d'un matériau magnétique et isolant électriquement comprenant une matrice (10) en un polymère isolant électriquement dans laquelle sont dispersées de façon homogène des particules (14) d'une substance magnétique comprenant au moins un métal de transition, le procédé comprenant les étapes successives suivantes :
exposition d'une poudre des particules (14) de la substance magnétique à des impulsions d'un rayonnement ultraviolet, d'où il résulte une désaimantation temporaire des particules ;
mélange de la poudre à un solvant contenant, en outre, un précurseur du polymère ; et
polymérisation du précurseur pour former la matrice du polymère isolant électriquement dans laquelle les particules sont dispersées de façon homogène.

2. Procédé selon la revendication 1, dans lequel le polymère est choisi parmi le groupe comprenant le poly(méthacrylate de méthyle) (PMMA), le polystyrène (PS), les fluoropolymères, le polybutadiène (BR), et les copolymères ou les mélanges d'au moins deux de ces composés.

3. Procédé selon la revendication 1 ou 2, dans lequel la substance magnétique est choisie parmi le groupe comprenant les éléments magnétiques, les ferrites, les oxydes magnétiques et les alliages magnétiques.

4. Procédé selon la revendication 1 ou 2, dans lequel la taille moyenne des particules (14) est comprise entre 0,01 µm et 0,5 µm.

5. Procédé selon l'une quelconque des revendications 1 à 4, dans lequel chaque particule (14) est au moins partiellement entourée de molécules greffées à ladite particule et comprenant un groupement hydrophobe et un groupement hydrophile.

6. Procédé selon la revendication 5, dans lequel les molécules sont choisies parmi le groupe comprenant le 4-fluorobenzo[d]thiazole-2-thiol (C₇H₄FNS₂), le 4-amino-2-fluorobenzenethiol (C₆H₆FNS), le benzènethiol (BT), le 4-nitrobenzènethiol (NBT), le 4-méthylbenzènethiol (MBT), le 4-hydroxybenzènethiol (HBT), le 4-méthoxybenzènethiol (MOBT), le 4-fluorobenzènethiol (FBT), le pentafluorobenzènethiol (PFBT), le 4-chlorobenzènethiol (CBT), le pentachlorobenzènethiol (PCBT), le 4-bromobenzènethiol (BBT) , et un mélange d'au moins deux de ces composés.

7. Procédé selon la revendication 5, dans lequel les molécules comprennent au moins un groupement choisi parmi le groupe comprenant les groupements silanes, les amines, les acides phosphoriques, les acides carboxyliques ou les isocyanates.

8. Procédé selon l'une quelconque des revendications 1 à 7, dans lequel le rayonnement a une fluence comprise entre 1 J/cm² et 100 J/cm².

9. Procédé selon l'une quelconque des revendications 1 à 8, dans lequel le nombre d'impulsions est supérieur à 50.

10. Procédé selon l'une quelconque des revendications 1 à 9, dans lequel la durée de chaque impulsion est comprise entre 10 ns et 5 ms.

11. Procédé selon l'une quelconque des revendications 1 à 10, comprenant en outre le greffage aux particules (14) de molécules comprenant un groupement hydrophobe et un groupement hydrophile.

12. Matériau magnétique et isolant électriquement obtenu par le procédé selon l'une quelconque des revendications 1 à 11.

13. Matériau selon la revendication 12, dans lequel chaque particule (14) est au moins partiellement entourée de molécules greffées à ladite particule et comprenant un groupement hydrophobe et un groupement hydrophile.

14. Matériau selon la revendication 13, dans lequel les molécules sont choisies parmi le groupe comprenant le 4-fluorobenzo[d]thiazole-2-thiol (C₇H₄FNS₂), le 4-amino-2-fluorobenzenethiol (C₆H₆FNS), le benzènethiol (BT), le 4-nitrobenzènethiol (NBT), le 4-méthylbenzènethiol (MBT), le 4-hydroxybenzènethiol (HBT), le 4-méthoxybenzènethiol (MOBT), le 4-fluorobenzènethiol (FBT), le pentafluorobenzènethiol (PFBT), le 4-chlorobenzènethiol (CBT), le pentachlorobenzènethiol (PCBT), le 4-bromobenzènethiol (BBT) , et un mélange d'au moins deux de ces composés.

15. Film (10) magnétique et isolant électriquement comprenant le matériau selon l'une quelconque des revendications 12 à 14.
